# EUROPÄISCHE PATENTSCHRIFT

(11) **EP 2 315 352 B1**
(45) Veröffentlichungstag und Bekanntmachung des Hinweises auf die Patenterteilung: **25.11.2020**
(21) Anmeldenummer: 10013499.8
(22) Anmeldetag: 11.10.2010
(51) Int. Cl.: H03G 3/30

(54) **Kompensationsschaltung zur Verbesserung der Pegelregelung integrierter Verstärkerbausteine**
Compensation circuit for improving the level regulation of integrated amplifier components
Circuit de compensation pour l'amélioration de la régulation de niveau de composants d'amplificateur intégrés

(30) Priorität: 23.10.2009 DE 102009050491
(43) Veröffentlichungstag der Anmeldung: 27.04.2011
(73) Patentinhaber: Rohde & Schwarz GmbH & Co. KG, 81671 München (DE)
(72) Erfinder: Saglam, Mustafa, Dr., 83022 Rosenheim (DE); Ambrozkiewicz, Mikolaj, 22115 Hamburg (DE); Kraemer, Wilhelm, 83435 Bad Reichenhall (DE)
(74) Vertreter: Körfer, Thomas

(56) Entgegenhaltungen:
- WO-A1-99/60698
- US-A1- 2002 183 021
- US-A1- 2006 192 616
- US-B1- 6 430 402
- US-B1- 7 433 658

## Beschreibung

Die Erfindung betrifft eine Anordnung zur Pegelregelung integrierter Verstärkerbausteine, die in einem weiten Frequenzbereich betrieben werden.

Eine gattungsgemäße Anordnung zur Pegelregelung ist aus der EP 0 834 987 A2 bekannt. Bei dieser Anordnung wird ein Hochfrequenz-Signal durch einen Leistungsverstärker verstärkt. Ein Richtkoppler führt einen Teil des Ausgangssignals einer Detektionseinheit zu. Die von der Detektionseinheit ausgegebene Gleichspannung, welche ein Indiz für den Ausgangspegel ist, wird zusammen mit einer Steuerspannung, die als Pegelvorgabe dient, einem Komparator zugeführt. Das Ausgangssignal des Komparators dient als Stellgröße für die Verstärkung des Leistungsverstärkers. Die Detektionseinheit beinhaltet neben einer Detektordiode zusätzlich eine Referenzdiode, um die Temperaturdrift der Detektordiode zu kompensieren. Beide Dioden werden mit einer Vorspannung (BIAS) betrieben, die von einer konstanten Spannungsquelle bereit gestellt wird. Soll, wie in dieser Anordnung, nur ein schmalbandiger Betriebsbereich (GSM) abgedeckt werden, so kann unter Verwendung eines in diesem Bereich kostengünstigen Richtkopplers und einer externen Vorspannung der Dioden, ein befriedigendes Ergebnis erzielt werden. Wird der Betriebsbereich allerdings auf mehrere Oktaven ausgedehnt, so sind die Anforderungen an den Richtkoppler höher, was sich zum einen in der Größe des Bauteils und zum anderen im Preis wiederspiegelt.

Die US 6,430,402 B1 offenbart Vorrichtung zur Verhinderung der Sättigung eines Leistungsverstärkers. Diese Vorrichtung verfügt über ein Strommessglied, das mit Hilfe eines Signalprozessors ein Referenzsignal zur Verhinderung einer Sättigung in einer Verstärkerstufe erzeugt. Mit diesem Referenzsignal und einem vom Leistungsdetektor erzeugten Detektorsignal wird durch einen Komparator ein Steuersignal erzeugt, das die Verstärkung eines Leistungsverstärkers einstellt. Der Vorgabewert zum sättigungsfreien Betrieb für das Referenzsignal in Abhängigkeit zum Detektorsignal ist in einem nichtflüchtigen Speicher abgelegt.

Die US 2006/0192616 A1 zeigt eine elektronische Vorrichtung zur automatischen Einstellung eines Startpegels.

Die WO 99/60698 A1 offenbart eine HF-Verstärkerschaltung, deren Versorgungsstrom anpassungsfähig ist, bestehend aus einem HF-Leistungsverstärker, einem Signaldetektor, einem Signalprozessor, einem Stromdetektor und einer Stromversorgung. Mit einem Controller wird in einem Regelkreis ein mittlerer Versorgungsstrom vorgegeben, der mit einem Pegel einer Hüllkurve eines Ausgangssignals variiert. Eine Variante eines Signaldetektors enthält eine Schaltung zur Temperaturkompensation die dazu vorgesehen ist, durch Temperaturschwankungen des Detektorsignals zu ermitteln und damit den Versorgungsstrom der Verstärkerschaltung zu verringern.

US2002/0183021 A1 offenbart eine Regelung für die Leistung des Ausgangssignals eines Leistungsverstärkers in Abhängigkeit von der detektierten Leistung des Ausgangssignals und von der Stromaufnahme der Verstärkereinheit.

Der Erfindung liegt daher die Aufgabe zugrunde, eine stabile und genaue Pegelregelung über einen großen Frequenzbereich mit möglichst kostengünstigen Bauteilen zu schaffen, die auch für einen Verstärker in integrierter Bauweise geeignet ist.

Die Aufgabe wird durch die erfindungsgemäße Kompensationsschaltlung mit den Merkmalen des Anspruchs 1 gelöst. Die Unteransprüche enthalten vorteilhafte Weiterbildungen der Erfindung.

Die Erfindung eignet sich für integrierte Verstärkerbausteine, die in einem weiten Frequenzbereich von beispielsweise 30 kHz bis 40 GHz betrieben werden können und u.a. für Kommunikationssysteme und Mikrowellenanwendungen gedacht sind. Verstärkerbausteine mit diesen Eigenschaften verfügen über Transistoren mit hoher Elektronenbeweglichkeit und werden von verschiedenen Herstellern unter den Bezeichnungen HEMT (High Electron Mobility Transistor) oder PHEMT (Pseudomorphic High Electron Mobility Transistor) als integrierte Verstärkerbausteine, die u.a. in einem MMIC (Monolithic Microwave Integrated Circuit) Prozess hergestellt werden, angeboten. Die Verstärkereinheiten verfügen in der Regel über mehrere kaskadierte Verstärkerstufen.

Zusätzlich umfassen die Verstärkereinheiten zumindest ein Detektorelement und zumindest ein Referenzelement, die bevorzugt aus zumindest einer Detektordiode und zumindest einer Referenzdiode bestehen. Das Detektorelement dient dabei zur Detektion der Ausgangsleistung der Verstärkereinheit. Das Referenzelement dient zur Kompensation des Temperaturgangs des Detektorelements, weil insbesondere die Detektordiode ein temperaturabhängiges Verhalten aufweist. Aufgrund der angestrebten hohen Bandbreite können Richtkoppler nicht wirtschaftlich eingesetzt werden, weil die benötigte Chipfläche signifikant zunehmen würde. Eine kapazitive Ankopplung der Detektordiode scheitert ebenfalls an der signifikanten Zunahme der benötigten Chipfläche, um die notwendige Koppelkapazität realisieren und integrieren zu können. Aus diesem Grund wird bei diesen Verstärkereinheiten das Detektorelement galvanisch mit Ausgangssignal der Verstärkereinheit verbunden. Das Detektorelement wird hierfür meistens mit der HF-führenden Leitung verbunden, die meist auch die Drain-Versorgungsspannung führt. Diese Verbindung kann über einen Spannungsteiler erfolgen. Die Vorspannung der Referenzdiode kann bei vielen Verstärkereinheiten separat zugeführt werden, bei einigen ist diese aber auch fest mit dem Drain am Eingang der Verstärkereinheit verbunden. Bei keinem der bekannten Verstärkereinheiten ist das Referenzelement allerdings an derselben Stelle des Drains angeschlossen wie das Detektorelement, weil es ohne Dämpfung des Ausgangssignals nicht ohne weiteres möglich ist, den Wechselanteil des Ausgangssignals von der Referenzdiode zu entkoppeln.

Wird nun, wie in den meisten Verstärkereinheiten, die Referenzdiode mit der Drainspannung, wie sie am Eingang der Verstärkereinheit anliegt, vorgespannt, so unterscheidet sich die Vorspannung an der Referenzdiode von der Vorspannung an der Detektordiode je nach Lastzustand der Verstärkereinheit. Dies ist auf den Spannungsabfall auf der Drainleitung zurückzuführen, der durch das Ausbilden von parasitären Impedanzen auf den Bondleitungen und den Zuleitungen in der Verstärkereinheit hervorgerufen wird. Bei einem hohen Ausgangspegel der Verstärkereinheit steigt die Stromaufnahme der Verstärkereinheit über die Drainleitung an, was dazu führt, dass der Spannungsabfall über die parasitären Impedanzen auf der Drainleitung ebenfalls zunimmt und die Vorspannung der Detektordiode deutlich unter der von der Referenzdiode liegt.

Die Vorspannung der Referenzdiode erfährt hingegen keinen merklichen Spannungsabfall, weil sie keine signifikante Stromaufnahme aufweist. Bei Verwendung eines bekannten Regelverfahrens, z.B. dem aus der EP 0 834 987 A2, würde sich für den Fall, dass die Detektorspannung oberhalb einer Steuerspannung liegt, Folgendes ergeben: Der Regler würde zuerst den Verstärkungsfaktor der Verstärkereinheit verringern. Dadurch würde die Stromaufnahme der Verstärkereinheit absinken, wodurch der Spannungsabfall, der weitestgehend proportional zur Stromaufnahme auf der Drainleitung der Verstärkereinheit ist, reduziert wird, was wiederum zufolge hat, dass die Vorspannung der Detektordiode ansteigt und sich dadurch der Arbeitspunkt auf der Kennlinie der Detektordiode verschiebt und damit die Ausgangsspannung an der Detektordiode ansteigt. Obwohl der Ausgangspegel bereits abgesunken ist, wird dem Regler mitgeteilt, dass der Ausgangspegel nicht abgesunken ist, weshalb dieser den Verstärkungsfaktor weiterhin absenkt. In einen stabilen Zustand wird der Regler dadurch nicht gelangen.

Dasselbe Problem ergibt sich im umgekehrten Fall, wenn die Ausgangsleistung erhöht werden soll. Dieses Problem wird noch verstärkt, wenn beide Dioden nicht in einem separaten Schottky-Prozess hergestellt werden. Die Dioden einiger Verstärkereinheiten scheinen durch einen Metall-Halbleiter-Feldeffekttransistor (MESFET) gebildet zu sein, dessen Leistungsfähigkeit unterhalb derer einer dedizierten Schottky-Diode liegt. Generell führt die angesprochene Problematik dazu, dass mit bekannten Verfahren keine der integrierten Detektordioden für eine genaue Pegelregelung nutzbar sind.

Das Konzept der Erfindung beruht auf der Tatsache, dass bei allen untersuchten Verstärkereinheiten der Spannungsabfall weitestgehend linear zur Stromaufnahme am Drain-Eingang ist. In der vorliegenden Erfindung wird die Stromaufnahme am Draineingang der Verstärkereinheit über zumindest ein Strommessglied gemessen. Das Strommessglied umfasst dabei bevorzugt zumindest einen Shuntwiderstand oder zumindest ein Hallelement. Das Stromsignal selbst wird über einen Differenzverstärker verstärkt, wobei gleichzeitig auch eine Impedanzanpassung erfolgt. Das Ausgangssignal des Differenzverstärkers, das Stromsignal, wird mit einem Korrekturfaktor K multipliziert. Der Korrekturfaktor K führt das gemessene Stromsignal in eine Fehlerspannung über, die zur Detektorspannung addiert werden muss, um dadurch den Spannungsabfall auf der Drainleitung zu kompensieren. Der Faktor K berücksichtigt neben der Höhe des Spannungsabfalls auch die Kennlinie der Detektordiode. Die Höhe des Spannungsabfalls ist, wie bereits dargelegt, von der Stromaufnahme, sowie von der Impedanz der Bondleitung und der Impedanz der Drainleitung abhängig und kann gemessen werden.

Der Korrekturfaktor K kann z.B. durch einen Spannungsteiler, oder durch ein Potentiometer, oder durch einen Operationsverstärker oder durch einen Digital/Analog-Wandler eingestellt werden. Von der Ausgangsspannung der Detektordiode wird die Ausgangsspannung der Referenzdiode abgezogen. Dies geschieht z.B. mittels eines Differenzverstärkers. Dem Ausgangssignal dieses Differenzverstärkers wird die mit dem Faktor K gewichtete Fehlerspannung addiert. Dies geschieht durch einen weiteren Operationsverstärker. Das Ausgangssignal dieses weiteren Operationsverstärkers wird dem Eingang eines Reglers zugeführt. Der Regler kann als PI-Regler (proportional integral Regler) aufgebaut sein, wobei auch andere Reglerstrukturen möglich sind. Eine Sollwertvorgabe, in Form einer Steuerspannung, die abhängig vom, vorzugsweise proportional zum Ausgangspegel ist, wird ebenfalls dem Regler zugeführt. Der Regler kann durch analoge Elemente, wie z.B. Operationsverstärker oder durch zeitdiskret arbeitende Elemente, wie z.B. Mikroprozessoren oder FPGAs aufgebaut sein. Der Regler kann auch in einem Regelrechengerät implementiert sein.

Der Ausgang des Reglers ist mit zumindest einem Eingang der Verstärkereinheit verbunden, über den der Verstärkungsfaktor eingestellt werden kann. Die hierfür notwendige Regelgröße wird bevorzugt direkt vom Regler erzeugt. Die notwendige Regelgröße kann allerdings auch von einem Digital/Analog-Wandler, der mit dem Regelrechengerät verbunden ist, erzeugt werden. Die Regelgröße am Ausgang des Reglers ist nicht nur von dem Detektorsignal und dem Referenzsignal abhängig, sondern auch zusätzlich von der Stromaufnahme der Verstärkereinheit.

Ein bei manchen Verstärkereinheiten zusätzlicher Eingang zur Einstelllung des Arbeitspunktes ist bevorzugt über eine Steuergröße einstellbar. Diese Steuergröße kann in der ersten erfindungsgemäßen Ausführungsform als konstant betrachtet werden. In einer weiteren erfindungsgemäßen Ausführungsform kann diese Steuergröße durch einen Digital/Analog-Wandler, der mit einem zeitdiskret arbeitenden Regelrechengerät verbunden ist, bereit gestellt werden. An das Regelrechengerät können zumindest zwei Analog/Digital-Wandler angeschlossen werden, über die zum einen die Stromaufnahme der Verstärkereinheit und zum anderen der um die Temperaturdrift kompensierte Ausgangspegel digital gemessen werden. An das Regelrechengerät sind bevorzugt ebenfalls zumindest zwei Digital/Analog-Wandler angeschlossen, die zwei Regelgrößen ausgeben, über die zum einen der Arbeitspunkt und zum anderen der Verstärkungsfaktor der Verstärkereinheit eingestellt werden kann. Das Regelrechengerät selbst ist dabei vorzugsweise mit einem übergeordneten Steuersystem verbunden. Sollwertvorgaben werden von diesem übergeordneten Steuersystem empfangen und Messgrößen werden an das übergeordnete Steuersystem übertragen.

Durch diese erfindungsgemäße Kompensation wird eine unerwünschte Mitkopplung über eine Modulation der Vorspannung der Detektordiode mit dem Hochfrequenzsignal vermieden und die Regelung wird stabil in Gegenkopplung betrieben. Die Regelung ist weiterhin geeignet, um sehr schnell und genau einen gewünschten Ausgangspegel bei einer gewünschten Frequenz für interne Signalquellen einzustellen. Weiterhin kann durch Nutzung des internen Detektorelements auf den Einsatz von externen breitbandigen Kopplern und zusätzlichen Leistungsdetektoren verzichtet werden. Dadurch verbessert sich zusätzlich das Rauschverhalten gegenüber bekannten Lösungen. Messungen haben gezeigt, dass ohne die Erfassung und Rückführung des Drainstroms eine Pegelabweichung von bis zu +/- 5 dB, je nach Eingangsleistung, gegenüber dem Sollwert auftritt. Unter Verwendung der Pegelregelung gemäß vorliegender Erfindung liegt die Pegelabweichung bei unter +/- 0,3 dB gegenüber dem vorgegebenen Sollwert.

Verschiedene Ausführungsbeispiele der Erfindung werden nachfolgend unter Bezugnahme auf die Zeichnung beispielhaft beschrieben. Gleiche Gegenstände weisen dieselben Bezugszeichen auf. Die entsprechenden Figuren der Zeichnung zeigen im Einzelnen:
- Fig. 1: ein Blockschaltbild eines erfindungsgemäßen Ausführungsbeispiels, das eine Gesamtübersicht der erfindungsgemäßen Anordnung zur Pegelregelung integrierter Verstärkereinheiten beinhaltet;
- Fig. 2: einen schematischen Aufbau der Verstärkereinheit eines erfindungsgemäßen Ausführungsbeispiels mit verschiedenen Verstärkerstufen und dem Anschluss der Detektordiode und der Referenzdiode, wie er in unterschiedlichen integrierten Verstärkereinheiten realisiert sein kann;
- Fig. 3A: eine Erfassung und Aufbereitung des Drainstroms gemäß eines erfindungsgemäßen Ausführungsbeispiels;
- Fig. 3B: eine weiteres Ausführungsbeispiel zur Erfassung und Aufbereitung des Drainstroms gemäß der Erfindung;
- Fig. 4: ein Ausführungsbeispiel eines PI-Reglers gemäß eines erfindungsgemäßen Ausführungsbeispiels;
- Fig. 5A: ein Ausführungsbeispiel unter Verwendung eines zeitdiskret arbeitenden Regelrechengerätes gemäß der Erfindung und
- Fig. 5B: ein weiteres Ausführungsbeispiel unter Verwendung eines zeitdiskret arbeitenden Regelrechengerätes gemäß der Erfindung.

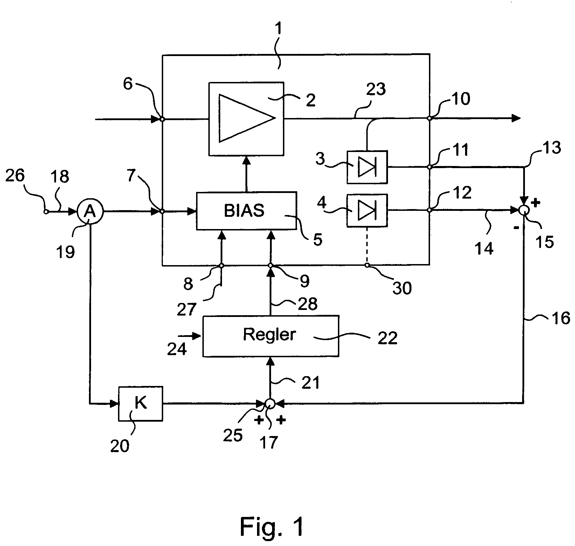

Fig. 1 zeigt ein überblickartiges Blockschaltbild der erfindungsgemäßen Anordnung zur Pegelregelung integrierter Verstärkereinheiten. Die Verstärkereinheit 1 ist meistens als integrierter Baustein realisiert. Diese Verstärkereinheit 1 kann z.B. durch einen MMIC-Prozess als integrierte Verstärkereinheit hergestellt werden. Diese beinhaltet einen Leistungsverstärker 2 der aus mehreren kaskadierten Verstärkerstufen bestehen kann. Das vom Leistungsverstärker 2 erzeugte Hochfrequenz-Signal, im Folgenden HF-Signal 23, wird einem Detektorelement 3, das mit dem Ausgang des Leistungsverstärkers 2 verbunden ist, zugeführt. In der Verstärkereinheit 1 befindet sich zusätzlich ein Referenzelement 4 und eine Einrichtung 5 zum Einstellen der Vorspannungen (Bias) des Leistungsverstärkers 2.

Die Verstärkereinheit 1 umfasst einen Eingang 6, an dem das zu verstärkende HF-Signal angelegt wird. Weiterhin umfasst die Verstärkereinheit 1 einen Eingang 7 an den die Drainspannung 18 angelegt wird. Über einen weiteren Eingang 8 kann der Arbeitspunkt des Leistungsverstärkers 2 eingestellt werden. Über den Eingang 9 kann der Verstärkungsfaktor des Leistungsverstärkers 2 eingestellt werden. Über den Ausgang 10 kann das HF-Signal 23 weiteren Einrichtungen zugeführt werden. Am Ausgang 11 liegt das Detektorsignal 13 des Detektorelements 3 an. Am Ausgang 12 liegt das Referenzsignal 14 des Referenzelements 4 an.

Der temperaturabhängige Fehler des Detektorsignals 13 wird mittels des Referenzsignals 14 durch einen Differenzverstärker 15 kompensiert. Dieser Differenzverstärker 15 ist durch analoge Bausteine wie z.B. Operationsverstärker aufgebaut. Das Ausgangssignal 16 des Differenzverstärkers 15 wird auf einen ersten Eingang eines Addierers 17 geleitet. Über ein Strommessglied 19 wird die Stromaufnahme des Drains gemessen. Das Strommessglied 19 kann aus einem Shuntwiderstand und/oder aus einem Hallelement bestehen. Der gemessene Strom wird über einen in Figur 1 nicht dargestellten Operationsverstärker verstärkt und mit einem Faktor K in einem Block 20 gewichtet. Diese Gewichtung kann z.B. mittels eines Potentiometers und/oder eines Spannungsteilers und/oder eines Digital/Analog-Wandlers und/oder eines weiteren Operationsverstärkers erfolgen. Anschließend wird das mit dem Faktor K gewichtete Stromsignal, welches nun die Fehlerspannung darstellt, um die das Detektorsignal 13 des Detektorelements 3 von dem tatsächlichen Wert abweicht, einem zweiten Eingang 25 des Addierer 17 zugeführt. Der Addierer 17 ist im Ausführungsbeispiel mit analogen Elementen wie z.B. einem Operationsverstärker aufgebaut.

Der Ausgang des Addierers 17 wird mit dem Eingang des Reglers 22 verbunden. An einen zweiten Eingang des Reglers 22 wird eine Steuerspannung 24 angelegt, die abhängig vom, vorzugsweise proportional zum gewünschten Hochfrequenz-Pegel am Ausgang 10 der Verstärkereinheit 1 ist. Die Verstärkereinheit 1 kann noch einen separaten Eingang 30 aufweisen, an welchen eine Spannung angelegt werden kann, mit der das Referenzelement 4 vorgespannt wird.

In einer weiteren Ausführungsform der vorliegenden Erfindung wird die Vorspannung für das Referenzelement 4 über einen Spannungsteiler abgesenkt. Dies kann bei Verstärkereinheiten 1, bei denen das Referenzsignal 14 mit einem starken Offset (Versatz-Spannung) behaftet ist, zu einer höheren Genauigkeit führen. Ein solcher Offset kann neben einem Spannungsteiler, der die Vorspannung des Referenzelements senkt, auch mittels eines Digital/Analog-Wandlers, der zusammen mit der Drainspannung mit einem Differenzverstärkers verbunden ist, kompensiert werden. Hierzu wird der Ausgang des Differenzverstärkers mit dem Eingang 30 verbunden.

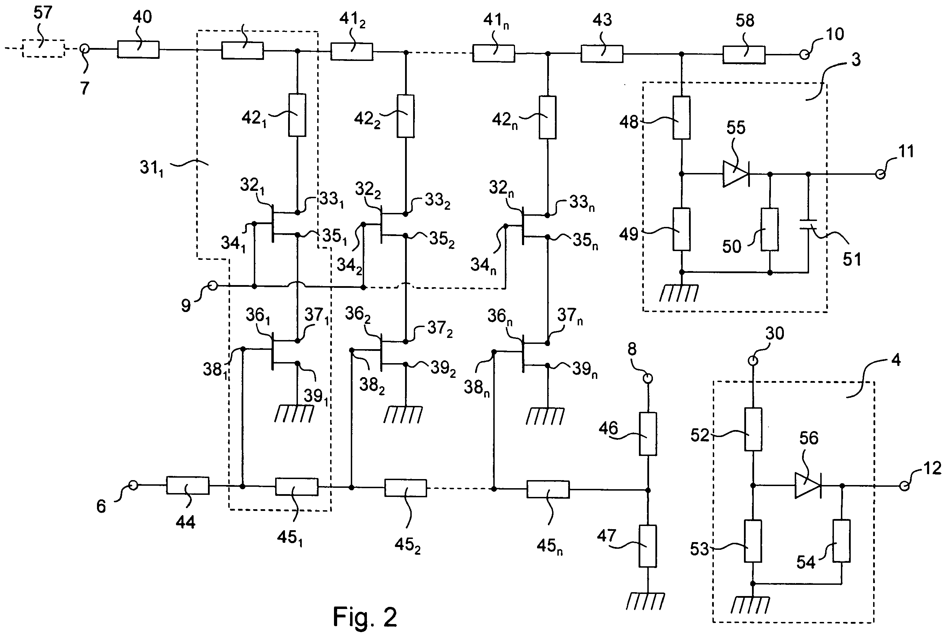

Fig. 2 zeigt schematisch dargestellt den beispielhaften Aufbau der Verstärkereinheit 1. Die Verstärkereinheit 1 beinhaltet zumindest eine Verstärkerstufe 31₁. Die Verstärkerstufe 31₁ beinhaltet zwei Transistoren 32₁, 36₁, die komplementär zueinander verschaltet sind. Ein erster Anschluss 33₁ eines ersten Transistors 32₁ wird über den Widerstand 42₁ mit der Drainleitung verbunden. Die Widerstände 41₁, 42₁ und 45₁ stellen parasitäre Leitungsimpedanzen dar, die sich auf den Zuleitungen zu den Transistoren bilden. Der zweite Anschluss 34₁ des ersten Transistors 32₁ ist mit dem Eingang 9 verbunden. Über die Steuerspannung, die am Eingang 9 anliegt, kann die Verstärkung der Verstärkereinheit 1 eingestellt werden.

Ein dritter Anschluss 35₁ des ersten Transistors 32₁ ist mit dem ersten Anschluss 37₁ des zweiten Transistors 36₁ verbunden. Der zweite Anschluss 38₁ des zweiten Transistors 36₁ ist dem zu verstärkenden HF-Signal verbunden. Ein dritter Anschluss 39₁ des zweiten Transistors 36₁ ist mit der Bezugsmasse verbunden. Neben der ersten Verstärkerstufe 31₁ kann es noch weitere Verstärkerstufen geben. In Fig. 2 sind beispielhaft zwei weitere Verstärkerstufen eingezeichnet, um die Funktionsweise besser zu veranschaulichen. Der Aufbau dieser Verstärkerstufen entspricht der bereits beschriebenen Verstärkerstufe 31₁. Einzig die Indizes 2 und n der Bezugszeichen unterscheiden sich bei den Verstärkerstufen. Die Widerstände 40, 43, 44 stellen ebenfalls parasitäre Leitungsimpedanzen dar oder dienen zum Abschluss der Leitung. Der Drain-Widerstand 57, über welchem die Summe der Drainströme abfällt, befindet sich vorzugsweise außerhalb des Gehäuses der integrierten Schaltung (IC), damit im IC-Gehäuse möglichst wenig Leistung dissipiert wird.

Über den Eingang 8 kann über einen Spannungsteiler 46, 47 eine Steuerspannung an die Sourceleitung angelegt werden, die sich mit dem HF-Signal, das am Eingang 6 angelegt wird, überlagert. Durch den Gleichanteil der Steuerspannung wird der Arbeitspunkt der Transistoren 36₁, 36₂, 36ₙ über den zweiten Anschluss 38₁, 38₂, 38ₙ eingestellt. Der Verstärkungsfaktor der Verstärkerstufe 31₁, 31₂, 31ₙ wird über den Eingang 9 eingestellt. Die Steuerspannung am Eingang 9 kann mit einer weiteren Gleichspannung, die in Fig. 2 nicht dargestellt ist, überlagert werden. Dies kann z.B. über einen nicht dargestellten Spannungsteiler zur Drainleitung hin geschehen.

Über einen Spannungsteiler 48, 49 wird das verstärkte HF-Signal vor dem Ausgang 10 herunter geteilt und der Anode der Detektordiode 55 zugeführt. An der Kathode der Detektordiode 55 schließt sich neben einem Widerstand 50 auch ein Kondensator 51 gegen Masse an, um den Wechselanteil gegen Masse abzuleiten, so dass am Ausgang 11 ein reiner Gleichanteil erhalten bleibt. Die Widerstände 48, 49, 50, der Kondensator 51 und die Detektordiode 55 bilden das Detektorelement 3.

Ein weiterer Spannungsteiler 52, 53 teilt eine Spannung am Eingang 30 herunter, welcher meistens mit dem Eingang 7 der Drainleitung verbunden ist und führt diese der Anode der Referenzdiode 56 zu. An die Kathode der Referenzdiode 56 schließt sich der Ausgang 12 und ein Widerstand 54 gegen die Bezugsmasse an. Die Widerstände 52, 53, 54 und die Referenzdiode 56 bilden das Referenzelement 4.

In einer weiteren Ausführungsform der vorliegenden Erfindung ist der erste Anschluss 33₁, 33₂, 33ₙ, 37₁, 37₂, 37ₙ der Transistoren 32₁, 32₂, 32_{n,} 36₁, 36₂, 36ₙ mit dem Drain, ein zweiter Anschluss 34₁, 34₂, 34ₙ, 38₁, 38₂, 38ₙ der Transistoren 32₁, 32₂, 32_{n,} 36₁, 36₂, 36ₙ mit dem Gate und ein dritter Anschluss 35₁, 35₂, 35_{n,} 39₁, 39₂, 39ₙ der Transistoren 32₁, 32₂, 32_{n,} 36₁, 36₂, 36ₙ mit dem Source verbunden. Andere Anschlusskombinationen sind ebenfalls denkbar.

Anhand von Fig. 2 lässt sich die Problematik, die mit der Nutzung von integrierten Detektordioden zur Pegelregelung in breitbandigen Leistungsverstärkern einhergeht, nochmals verdeutlichen. Wird über eine konstante Steuerspannung am Eingang 8 der Arbeitspunkt der Transistoren 36₁, 36₂, 36ₙ fest eingestellt und liegt am Eingang 7 eine konstante Drainspannung an, so erhöht sich bei einer Erhöhung der Steuerspannung am Eingang 9 der Drainstrom, der in den Eingang 7 fließt. Eine erhöhte Stromaufnahme der Verstärkerstufen 31₁, 31₂, 31ₙ bewirkt einen erhöhten Spannungsabfall über die Widerstände 40, 41₁, 41₂, 41ₙ. Dies führt dazu, dass die Amplitude der Gleichspannung an der Anode der Detektordiode 55 sinkt, wobei sich der Arbeitspunkt auf der Kennlinie der Detektordiode 55 verschiebt und am Ausgang 11 der Detektordiode 55 eine niedrigere Spannung anliegt, obwohl das HF-Signal am Ausgang 10 eine größere Amplitude als zuvor aufweist. Die Anode der Referenzdiode 56 bleibt von dem Spannungsabfall unbetroffen, weil nur ein sehr geringer Strom über den Spannungsteiler fließt und der Eingang 30 mit dem Eingang 7 der Drainleitung verbunden ist.

Sollten die Verstärkerstufen 31₁, 32₂, 32ₙ der Verstärkereinheit 1 über den Ausgang 10 der Verstärkereinheit 1 mit einer konstanten Drainspannung versorgt werden, so würde ebenfalls ein Spannungsabfall über dem Bondwiderstand 58 dazu führen, dass sich die Vorspannung der Detektordiode 55 von der Vorspannung der Referenzdiode 56 unterscheidet, was die Verwendung der hier vorliegenden Erfindung ebenfalls unabdingbar macht.

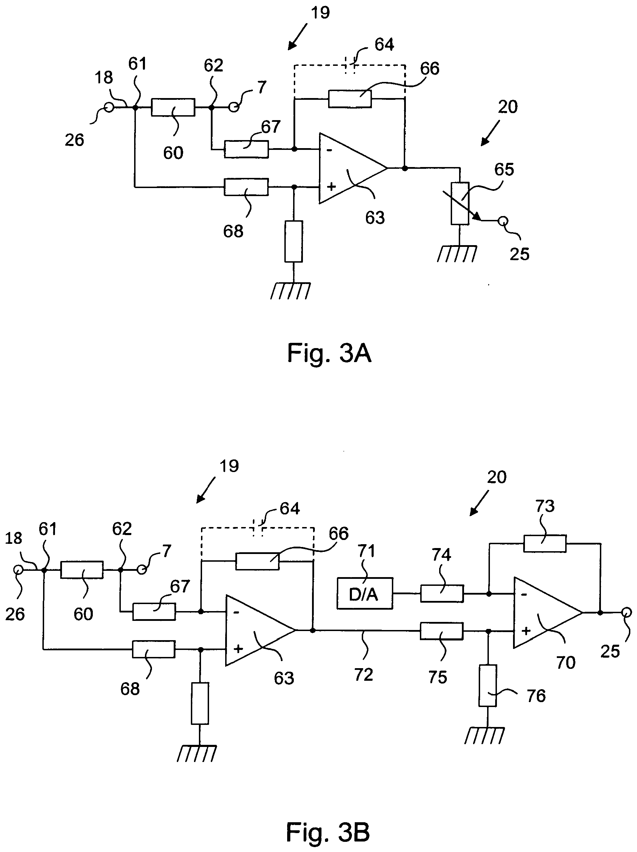

Fig. 3A zeigt die Erfassung und Aufbereitung des Drainstroms. Eine Drainspannung 18 wird am Eingang 26 angelegt. Über einen Shuntwiderstand 60 wird der Eingang 26 mit dem Eingang 7 der Verstärkereinheit 1 verbunden. Der Shuntwiderstand 60 kann aus mehreren Widerständen bestehen, die parallel miteinander verbunden sind. Über die Anschlüsse 61 und 62 wird die Spannung vor und nach dem Shuntwiderstand 60 z.B. über Widerstände 67, 68 einem als Differenzverstärker arbeitenden Operationsverstärker 63 zugeführt. Der Differenzverstärker kann durch Einfügen der Kapazität 64 parallel zum Widerstand 66 in der Rückkopplung zum Tiefpass 1. Ordnung erweitert werden. Die Grenzfrequenz des Filters muss dabei allerdings unterhalb der tiefsten zu verstärkenden Signalfrequenz liegen.

Der Differenzverstärker dient dazu, das Signal zu verstärken, um anschließend die gewünschte Gewichtung des Signals z.B. durch ein Potentiometer 65 einstellen zu können. Ebenfalls erfolgt durch den Differenzverstärker eine Impedanzanpassung. Ein Anschluss des Potentiometers 65 wird bevorzugt mit dem Ausgang des Differenzverstärkers verbunden. Ein zweiter Anschluss des Potentiometers 65 wird mit dem Eingang 25 eines Addierers 17 (siehe Fig. 1) verbunden und ein dritter Anschluss des Potentiometers 65 wird mit Masse verbunden. Das Potentiometer 65 kann als herkömmliches Potentiometer oder als digitales Potentiometer ausgeführt sein.

Fig. 3B zeigt eine vorteilhafte Weiterbildung für die Erfassung und Aufbereitung des Drainstroms. Der Drainstrom wird wie in Fig. 3A über zumindest einen Shuntwiderstand 60 erfasst und einem als Differenzverstärker arbeitenden Operationsverstärker 63 zugeführt. Das Ausgangssignal 72 wird einem ersten Eingang eines zweiten als Differenzverstärker arbeitenden Operationsverstärkers 70 z.B. über einen Widerstand 75 zugeführt. Der Widerstand 75 bildet zusammen mit einem weiteren Widerstand 76 einen Spannungsteiler. An den zweiten Eingang des Operationsverstärkers 70 wird neben einem Widerstand 73, der zur Rückkopplung dient, über einen weiteren Widerstand 74 ein Digital/Analog-Wandler (D/A-Wandler) 71 angeschlossen. Gegenüber einem digitalen Potentiometer sind die Abstufungen bei einem D/A-Wandler 71 deutlich feiner. Am Ausgang 25 wird je nach Größe der Widerstände des Differenzverstärkers und der angelegten Spannung durch den D/A-Wandler das Spannungssignal 72 unterschiedlich stark gewichtet. Diese Gewichtung kann im laufenden Betrieb angepasst werden. Dadurch ist der anhand von Fig. 1 beschriebene Korrekturfaktor K realisiert.

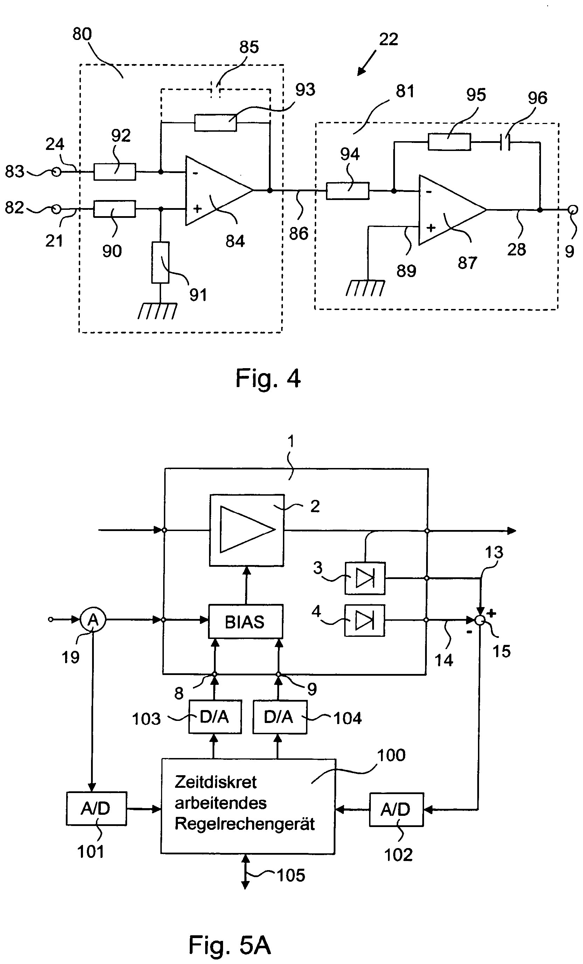

Fig. 4 zeigt eine mögliche erfindungsgemäße Ausgestaltung des Reglers 22 aus Fig. 1. Der Regler 22 besteht in Fig. 4 aus einem als Differenzverstärker 80 arbeitenden Operationsverstärker 84 und einem als proportional integrierter PI-Regler 81 arbeitenden Operationsverstärker 87. An einen ersten Anschluss 82 des Differenzverstärkers 80 wird das Ausgangssignal 21 des Addierers 17 aus Fig. 1 über eine Widerstand 90 angelegt. Der Widerstand 90 bildet zusammen mit dem Widerstand 91 einen Spannungsteiler. Das Ausgangssignal 21 aus Fig. 1 setzt sich aus dem gewichteten Stromsignal, das den Fehleranteil bezüglich des Spannungsabfalls der Drainspannung an den parasitären Impedanzen beinhaltet, sowie aus dem Referenzsignal 14 des Referenzelements 4, das den temperaturabhängigen Fehleranteil berücksichtigt und dem Detektorsignal 13 des Detektorelements 3 zusammen. Einem zweiten Eingang 83 wird eine Steuerspannung 24 über einen Widerstand 92 zugeführt, die proportional zum Ausgangspegel ist und als Sollwertvorgabe dient.

Der Differenzverstärker 80 kann durch Einfügen der Kapazität 85 parallel zum Widerstand 93 in der Rückkopplung als Tiefpass 1. Ordnung realisiert werden. Das Ausgangssignal 86 wird dem PI-Regler 81 zugeführt. Der über eine Widerstand 94 nachgeschaltete PI-Regler 81 beinhaltet einen Operationsverstärker 87, in dessen Rückführung ein Widerstand 95 und ein Kondensator 96 in Reihe geschaltet sind, so dass der Operationsverstärker 87 als Integrierer arbeitet. Der erste Eingang 89 des Operationsverstärkers 87 wird mit Masse verbunden. Die Stellgröße 28, die vom Regler 22 erzeugt wird und am Ausgang anliegt, wird an dem Anschluss 9 abgegeben.

In einer weiteren Ausführungsform der vorliegenden Erfindung wird auf den Differenzverstärker 80 verzichtet. Die Steuerspannung 24 zur Sollwertvorgabe wird mit dem ersten Eingang 89 des Operationsverstärkers 87 verbunden. Das Ausgangssignal 21 des Addierers 17 aus Fig. 1 wird mit dem zweiten Eingang des Operationsverstärkers 87 verbunden.

Fig. 5A zeigt eine weitere detaillierte Ausführungsform der vorliegenden Erfindung. Fig. 5A beinhaltet mit der Verstärkereinheit 1, dem Differenzverstärker 15 und dem Strommessglied 19 die wesentlichen Komponenten, die schon in Fig. 1 vorhanden sind. Der Regler 22 aus Fig. 1, der in Fig. 4 detailliert dargestellt ist, sowie die Überlagerung des gemessenen Stromwerts mit einem konstanten Korrekturfaktor K, wie auch der Addierer 17, der das korrigierte Detektorsignal 16 mit dem korrigierten Stromsignal überlagert, werden bei diesem Ausführungsbeispiel durch ein zeitdiskret arbeitendes Regelrechengerät 100 ersetzt. Das Regelrechengerät 100 beinhaltet einen Mikroprozessor oder vorteilhafterweise einen programmierbaren Logikbaustein (FPGA). An das Regelrechengerät 100 ist zumindest ein Analog/DigitalWandler (A/D-Wandler) 101, 102 und/oder zumindest ein Digital/Analog-Wandler (D/A-Wandler) 103, 104 angeschlossen. Bei dem A/D-Wandler oder dem D/A-Wandler kann es sich um Bausteine handeln, die mehrere Eingangs-, bzw. Ausgangskanäle aufweisen. Bevorzugt wird allerdings für jedes der zu messenden Signale und für jede auszugebende Größe ein separater A/D-Wandler oder ein separater D/A-Wandler verwendet. Für geringere Genauigkeitsanforderungen können die A/D-Wandler 101, 102 und die D/A-Wandler 103, 104 auch im Regelrechengerät integriert sein, z.B. im Mikroprozessor. Das Regelrechengerät 100 ist vorteilhafterweise mit einem übergeordneten Steuergerät über eine digitale Schnittstelle 105 verbunden, z.B. eine SPI-Schnittstelle. Über diese digitale Schnittstelle 105 können Sollwertvorgaben für den einzustellenden Pegel vorgegeben werden.

Es können aber auch die gemessenen Werte der A/D-Wandler an das übergeordnete Steuergerät übertragen werden. Über einen nicht dargestellten optionalen A/D-Wandler kann auch eine analoge Steuerspannung 24 als Sollwertvorgabe dem Regelrechengerät 100 zugeführt werden. Die Stromaufnahme der Drainleitung der Verstärkereinheit 1 kann über ein Strommessglied 19 erfolgen, wie es in Fig. 3A dargestellt ist. Das Strommessglied 19 aus Fig. 3A wird dann ohne das Potentiometer betrieben, wobei der Ausgang des Operationsverstärkers 63 direkt mit dem Eingang des A/D-Wandlers 101 verbunden ist. Es ist darauf zu achten, dass der A/D-Wandler in seinem ganzen Messbereich voll ausgesteuert wird, um dadurch die gesamte Auflösung nutzen zu können. Hierzu ist die Verstärkung am Operationsverstärker 63 über die Widerstände entsprechend einzustellen.

In einer weiteren Ausführungsform kann dieser Differenzverstärker auch durch einen vollständigen Differenzverstärker ersetzt werden, der am Ausgang eine differentielle Spannung ausgibt. Diese beiden Spannungen werden dem A/D-Wandler 101 zugeführt werden, der die Spannungsdifferenz der beiden Eingangsspannungen ermittelt. Das Referenzsignal 14 des Referenzelements 4 und das Detektorsignal 13 des Detektorelements 3 werden durch einen Differenzverstärker 15 soweit verstärkt, dass der A/D-Wandler 102 möglichst voll ausgesteuert ist und die ganze Auflösung nutzbar ist. Das Regelrechengerät 100 liest in konstanten Intervallen T_{A} die Werte der A/D-Wandler 101, 102 ein und berechnet anhand eines zeitdiskreten Modells der Übertragungsstrecke zusammen mit dem vorgegebenen Sollwert die auszugebenenden Stellgrößen.

Die A/D-Wandler beginnen im selben Zeitpunkt die zu messenden Signale zu erfassen. Die Stellgrößen beziehen sich auf den Verstärkungsfaktor und den Arbeitspunkt des Leistungsverstärkers 2. Die Stellgröße für die Einstellung des Arbeitspunktes des Leistungsverstärkers 2 wird an den D/A-Wandler 103 übermittelt, der mit dem Eingang 8 der Verstärkereinheit 1 verbunden ist. Die Stellgröße für den Verstärkungsfaktor Leistungsverstärkers 2 wird an den D/A-Wandler 104 übermittelt, der mit dem Eingang 9 der Verstärkereinheit 1 verbunden ist. In dem Regelrechengerät 100 können neben einem PI-Regler auch komplexere Reglerstrukturen realisiert werden.

In einer weiteren Ausführungsform der vorliegenden Erfindung wird eine Tabelle (Lookuptable) implementiert, die einen Korrekturfaktor enthält, der zur gemessenen aber fehlerbehafteten Detektorspannung 13 addiert werden muss, um den Messfehler, der durch den Spannungsabfall an den parasitären Impedanzen hervorgerufen wird, zu kompensieren. Hierzu wird dem Regelrechengerät 100 noch die Betriebsfrequenz z.B. über die digitale Schnittstelle 105 zugeführt. Der eingestellte Arbeitspunkt und der Verstärkungsfaktor sind bekannt, so dass der Korrekturfaktor aus der Tabelle(Lookuptable) ausgelesen werden kann. Die Tabelle (Lookuptable) wird vorzugsweise einmalig erstellt und in einem nicht flüchtigen Speicher gespeichert.

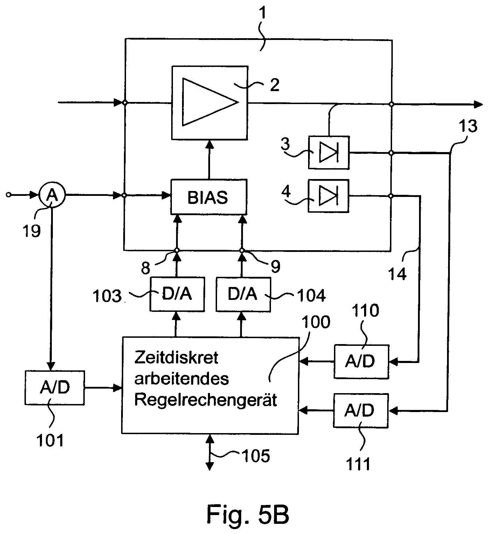

Fig. 5B zeigt eine weitere Ausführungsform der vorliegenden Erfindung. Im Gegensatz zu Fig. 5A wird das Referenzsignal 14 des Referenzelements 4 einem A/D-Wandler 110 und das Detektorsignal 13 des Detektorelements 3 einem A/D-Wandler 111 zugeführt. Beide Signale 13, 14 können jeweils durch einen nicht dargestellten Operationsverstärker verstärkt werden, so dass die ganze Auflösung der A/D-Wandler 110, 111 nutzbar ist. Das Regelrechengerät 100 erfasst das Detektorsignal 13 und das Referenzsignal 14 jeweils separat. Dadurch können Fehler zum einen besser erkannt werden und zum anderen kann das zeitdiskrete Modell der Übertragungsstrecke optimiert werden.

Die Erfindung ist nicht auf die dargestellten Ausführungsbeispiele begrenzt. Die vorliegende Erfindung ist auch für eine Pegelregelung von Verstärkereinheiten anwendbar, die mehr als ein HF-Signal verstärken können und über integrierte Detektorelemente verfügen. Weiterhin ist die Erfindung ebenfalls für eine Pegelregelung von Verstärkereinheiten anwendbar, die statt einem massebezogenen (unsymmetrischen) Signal ein differentielles (symmetrisches) Signal verstärken und dabei über integrierte Detektorelemente verfügen. Alle beschriebenen und/oder bezeichneten Elemente sind im Rahmen der Erfindung beliebig miteinander kombinierbar.

In einem weiteren nicht dargestellten Ausführungsbeispiel der vorliegenden Erfindung können bei Verwendung eines zeitdiskreten Regelrechengerätes sämtliche Filter auch als digitale Filter im zeitdiskreten Regelrechengerät implementiert werden. Dies betrifft unter anderem die Filter, die den A/D-Wandlern vorgeschalten sind. Dadurch ist es möglich, den analogen Teil auf wenige Komponenten zu beschränken, wohingegen der digitale Teil des Regelsystems, der neben der Filterstruktur auch die Reglerstruktur umfasst, je nach Anwendungsfall angepasst werden kann. So kann die Grenzfrequenz des Filters oder gar der Filtertyp, bzw. der Regler je nach Lastzustand, Betriebsfrequenz oder Benutzerwunsch im laufenden Betrieb gewechselt werden.

Der Einsatz eines zeitdiskret arbeitenden Regelrechengeräts in Kombination mit einem analogen Regler ist ebenfalls möglich. Das zeitdiskret arbeitende Regelrechengerät liest über einen A/D-Wandler die IstWerte ein und gibt dem analogen Regler über einen D/A-Wandler einen Sollwert vor.

In einem weiteren nicht dargestellten Ausführungsbeispiel der vorliegenden Erfindung ist auch eine direkte Steuerung der A/D-Wandler und D/A-Wandler durch das übergeordnete Steuergerät möglich.

## Patentansprüche

1. Kompensationsschaltung für eine Pegelregelung, wobei die Kompensationsschaltung eine Verstärkereinheit (1) umfasst, wobei die Verstärkereinheit (1) zumindest eine Verstärkerstufe (31₁) und zumindest ein Detektorelement (3) zur Detektion der Ausgangsleistung der Verstärkereinheit (1) aufweist,
wobei die Stromaufnahme der Verstärkereinheit (1) über zumindest ein Strommessglied (19) der Kompensationsschaltung messbar ist, wobei die Kompensationsschaltung so ausgebildet ist, dass ein von dem Strommessglied (19) gemessenes Stromsignal in der Kompensationsschaltung mit einem Korrekturfaktor (K) multipliziert wird,
wobei eine Verstärkung der Verstärkereinheit (1) über eine Regelgröße (28) einstellbar ist, die von einem Detektorsignal (13), das von dem Detektorelement (3) erzeugt wird, und von dem mit dem Korrekturfaktor multiplizierten Stromsignal abhängig ist,
**dadurch gekennzeichnet,**
**dass** das Detektorelement (3) galvanisch mit einer Ausgangsleitung der Verstärkereinheit (1) verbunden ist, und die Verstärkereinheit (1) weiterhin ein Referenzelement (4) umfasst, welches das temperaturabhängige Verhalten des Detektorelements (3) kompensiert.

2. Kompensationsschaltung nach Anspruch 1,
**dadurch gekennzeichnet,**
**dass** das Detektorelement (3) zumindest eine Detektordiode (55) umfasst.

3. Kompensationsschaltung nach Anspruch 1,
**dadurch gekennzeichnet,**
**dass** das Referenzelement (4) zumindest eine Referenzdiode (56) umfasst.

4. Kompensationsschaltung nach einem der vorhergehenden Ansprüche,
**dadurch gekennzeichnet,**
**dass** das Strommessglied (19) zumindest einen Shuntwiderstand (60) und/oder zumindest ein Hallelement umfasst.

5. Kompensationsschaltung nach einem der vorhergehenden Ansprüche,
**dadurch gekennzeichnet,**
**dass** der Korrekturfaktor (K) über zumindest einen Operationsverstärker (63) und/oder einen Spannungsteiler (65) und/oder einen Digital/Analog-Wandler (71) einstellbar ist.

6. Kompensationsschaltung nach Anspruch 5,
**dadurch gekennzeichnet,**
**dass** die Regelgröße (28) von einem Regler (22) erzeugt wird.

7. Kompensationsschaltung nach Anspruch 6,
**dadurch gekennzeichnet,**
**dass** der Regler (22) mit analogen Elementen oder mit zeitdiskreten Elementen aufgebaut ist.

8. Kompensationsschaltung nach Anspruch 6 oder 7,
**dadurch gekennzeichnet,**
**dass** der Regler (22) in einem Regelrechengerät (100) implementiert ist, an das zumindest ein Analog/DigitalWandler (101, 102) und/oder zumindest ein Digital/AnalogWandler (103, 104) angeschlossen ist.

## Claims

1. A compensation circuit for a level regulation, wherein the compensation circuit comprises an amplifier unit (1), wherein the amplifier unit (1) comprises at least one amplifier level (31₁) and at least one detector element (3) for the detection of an output power of the amplifier unit (1),
wherein the power consumption of the amplifier unit (1) is measurable via at least one current measurement element (19) of the compensation circuit, wherein the compensation circuit is embodied in such a manner that a current signal measured by the current measurement element (19) is multiplied in the compensation circuit by a correction factor (K),
wherein an amplification of the amplifier unit (1) is adjustable via a control variable (28), which is dependent upon a detector signal (13), which is generated by the detector element (3), and upon the current signal multiplied by the correction factor,
**characterised in that**
the detector element (3) is connected galvanically to an output conductor of the amplifier unit (1), and the amplifier unit (1) further comprises a reference element (4), which compensates the temperature-dependent behaviour of the detector element (3).

2. The compensation circuit according to claim 1,
**characterised in that**
the detector element (3) comprises at least one detector diode (55) .

3. The compensation circuit according to claim 1,
**characterised in that**
the reference element (4) comprises at least one reference diode (56) .

4. The compensation circuit according to any one of the preceding claims,
**characterised in that**
the current measurement element (19) comprises at least one shunt resistor (60) and/or at least one Hall element.

5. The compensation circuit according to any one of the preceding claims,
**characterised in that**
the correction factor (K) is adjustable via at least one operational amplifier (63) and/or a voltage splitter (65) and/or a digital-to-analog converter (71).

6. The compensation circuit according to claim 5,
**characterised in that**
the control variable (28) is generated by a regulator (22).

7. The compensation circuit according to claim 6,
**characterised in that**
the regulator (22) is constructed with analog elements or with time-discrete elements.

8. The compensation circuit according to claim 6 or 7,
**characterised in that**
the regulator (22) is implemented in a regulator computer (100), to which at least one analog-to-digital converter (101, 102) and/or at least one digital-to-analog converter (103, 104) is connected.

## Revendications

1. Circuit de compensation pour une régulation de niveau, dans lequel le circuit de compensation comprend une unité d'amplification (1), dans lequel l'unité d'amplification (1) présente au moins un étage d'amplification (31₁) et au moins un élément détecteur (3) destiné à détecter la puissance de sortie de l'unité d'amplification (1),
dans lequel la consommation de courant de l'unité d'amplification (1) peut être mesurée par l'intermédiaire d'au moins un élément de mesure de courant (19) du circuit de compensation, dans lequel le circuit de compensation est réalisé de sorte qu'un signal de courant mesuré par l'élément de mesure de courant (19) dans le circuit de compensation est multiplié par un facteur de correction (K),
dans lequel une amplification de l'unité d'amplification (1) peut être réglée par l'intermédiaire d'une grandeur de régulation (28), qui est produite par un signal de détecteur (13), qui est produit par l'élément détecteur (3), et dépend du signal de courant multiplié par le facteur de correction,
**caractérisé en ce**
**que** l'élément détecteur (3) est relié de manière galvanique à une ligne de sortie de l'unité d'amplification (1),
et l'unité d'amplification (1) comprend en outre un élément de référence (4), lequel compense le comportement, dépendant de la température, de l'élément détecteur (3).

2. Circuit de compensation selon la revendication 1,
**caractérisé en ce**
**que** l'élément détecteur (3) comprend au moins une diode de détection (55).

3. Circuit de compensation selon la revendication 1,
**caractérisé en ce**
**que** l'élément de référence (4) comprend au moins une diode de référence (56).

4. Circuit de compensation selon l'une quelconque des revendications précédentes,
**caractérisé en ce**
**que** l'élément de mesure de courant (19) comprend au moins un shunt résistif (60) et/ou au moins un élément à effet Hall.

5. Circuit de compensation selon l'une quelconque des revendications précédentes,
**caractérisé en ce**
**que** le facteur de correction (K) peut être réglé par l'intermédiaire d'au moins un amplificateur opérationnel (63) et/ou un diviseur de tension (65) et/ou un convertisseur numérique-analogique (71).

6. Circuit de compensation selon la revendication 5,
**caractérisé en ce**
**que** la grandeur de régulation (28) est produite par un régulateur (22).

7. Circuit de compensation selon la revendication 6,
**caractérisé en ce**
**que** le régulateur (22) est constitué d'éléments analogiques ou d'éléments temporels discrets.

8. Circuit de compensation selon la revendication 6 ou 7,
**caractérisé en ce**
**que** le régulateur (22) est implémenté dans un appareil de calcul de régulation (100), auquel au moins un convertisseur analogique/numérique (101, 102) et/ou au moins un convertisseur numérique/analogique (103, 104) est raccordé.
